# EUROPÄISCHE PATENTSCHRIFT

(11) **EP 1 764 832 B1**
(45) Veröffentlichungstag und Bekanntmachung des Hinweises auf die Patenterteilung: **06.11.2013**
(21) Anmeldenummer: 06017501.5
(22) Anmeldetag: 23.08.2006
(51) Int. Cl.: H01L 23/50

(54) **Bondverbindung für Leistungshalbleiterbauelemente**
Bonding connection for semiconductor power devices
Connexion de fixation pour des composants semiconducteurs de puissance

(30) Priorität: 24.08.2005 DE 102005039940
(43) Veröffentlichungstag der Anmeldung: 21.03.2007
(73) Patentinhaber: Semikron Elektronik GmbH & Co. KG Patentabteilung, 90431 Nürnberg (DE)
(72) Erfinder: Ebersberger, Frank, 90518 Hilpolstein (DE); Steger, Jürgen, 91335 Hilpoltstein (DE)

(56) Entgegenhaltungen:
- DE-A1- 10 204 157
- DE-A1- 19 549 011
- JP-A- 2000 049 280
- US-A1- 2003 042 619
- US-A1- 2004 178 498

## Beschreibung

### Beschreibung

Die Erfindung betrifft Bondverbindungen für Leistungshalbleiterbauelemente wie sie beispielhaft in Leistungshalbleitermodulen vielfältig Anwendung finden. Die Anforderungen und damit die Leistungsfähigkeit derartiger Leistungshalbleitermodule sowie der zu deren Aufbau notwendigen Leistungshalbleiterbauelemente sind in den letzten Jahren stetig gestiegen. Es stieg beispielhaft die Stromstärke pro Fläche der Halbleiterbauelemente. Weiterhin werden aus wirtschaftlichen Notwendigkeiten heraus die Halbleiterbauelemente immer näher an Ihrer Leistungsgrenze betrieben.

Entscheidende externe Faktoren für die Leistungsfähigkeit von Leistungshalbleitermodulen bzw. Leistungshalbleiterbauelementen sind die Wärmeabfuhr sowie die Stromzu- und -abführung. Stand der Technik in der Stromzu- und -abführung von Leistungshalbleiterbauelementen sind voll- oder teilflächige Lotverbindungen sowie Bondverbindungen in verschiedenen Ausgestaltungen, beispielhaft als Drahtbondverbindung oder als Bandbondverbindung. Hier soll die Leistungsfähigkeit derartiger Bondverbindungen betrachtet werden.

Drahtbondverbindung für Leistungshalbleiterbauelemente sind beispielhaft aus der DE 195 49 011 A1 bekannt. In diesen dort vorgestellten Leistungshalbleitermodulen werden die Leistungshalbleiterbauelemente mittels Lotverbindungen auf einem Substrat angeordnet. Diese Lotverbindung der zweiten Hauptfläche des Leistungshalbleiterbauelements stellt einen Teil der Stromzu- bzw. -abführung dar. Weitere Stromanschlüsse werden mittels Drahtbondverbindungen zwischen der Metallisierung der ersten Hauptfläche des Leistungshalbleiterbauelements und einer Leiterbahn hergestellt. Charakteristisch für die bekannten Drahtbondverbindungen ist, dass die Bonddrähte eng benachbart zueinander angeordnet sind, und dass die Bondfüße der einzelnen Bonddrähte, speziell auf der Metallisierung des Leistungshalbleiterbauelements, in einer Reihe angeordnet sind.

Nach dem Stand der Technik werden Leistungshalbleiterbauelemente nicht nur mittels einzelner nebeneinander angeordneter Bonddrähte mit der Leiterbahn der Stromzuführung kontaktiert, sondern häufig mit zwei oder mehreren in Richtung der Bonddrähte übereinander liegenden einzelnen Bonddrähten. Die einzelnen Bonddrähte werden häufig auch zur Verbesserung der Stromverteilung auf dem Leistungshalbleiterbauelement und / oder auf der Stromzuführung mittels mehrerer Bondfüße kontaktiert.

Simulationen zeigen, dass bei einer Anordnung der Bonddrähte zwischen einer Leiterbahn und einem Leistungshalbleiterbauelement nach dem Stand der Technik der Strom inhomogen über die Metallisierung in das Leistungshalbleiterbauelement eingespeist wird und somit dieses nicht in seiner gesamten Fläche gleichmäßig zur Stromführung belastet wird.

Die DE 102 04 157 A1 offenbart eine Drahtbondverbindung für die Strom leitende Verbindung einer Leiterbahn mit einem Leistungshalbleiterbauelement, wobei die Abstände von allen Bonddrähten oder innerhalb von einzelnen Gruppen von Bonddrähten variiert und somit die Stromeinspeisung in Richtung senkrecht zum Verlauf der Bonddrähte gegenüber dem Stand der Technik homogener gestaltet ist.

Nachteilig an dieser Ausgestaltung einer Drahtbondverbindung ist, dass hierbei eine genügen große Fläche der Metallisierung des Leistungshalbleiterbauelement zur Verfügung stehen muss um derartig komplexe Topologien sinnvoll einsetzen zu können.

Speziell bei Leistungshalbleitermodulen mit Dioden und Thyristoren sind Stoßstrombelastungen dieser Leistungshalbleiterbauelement besonders zu beachten. Diese Stoßströme übersteigen in einem kurzen Zeitraum in der Größenordnung von Zehntelsekunden die Dauerbelastung des Leistungshalbleiterbauelements um ein Vielfaches. Hierbei erweisen sich im Dauerbetrieb durchaus geeignet Ausgestaltungen von Bondverbindungen als wenig vorteilhaft.

Der vorliegenden Erfindung liegt die Aufgabe zugrunde eine Bondverbindung für Leistungshalbleiterbauelemente vorzustellen, wobei die maximale Stromtragfähigkeit der Bondverbindung in ihrer Gesamtheit, speziell bei Stoßstrombelastung, verbessert wird.

Diese Aufgabe wird gelöst durch Maßnahmen nach dem Anspruch 1, spezielle Ausgestaltungen finden sich in den Unteransprüchen.

Der Grundgedanke der Erfindung liegt darin, die Stromdichte auf der den Laststrom leitende Metallisierung des Leistungshalbleiterbauelements homogen zu auszuführen. Die hier betrachteten Leistungshalbleiterbauelemente sind beispielhaft ungesteuerter Bauelemente wie Leistungsdioden, oder auch gesteuerte Bauelemente wie Leistungsthyristoren oder Leistungstransistoren. Diese gesteuerten Bauelemente weisen zu ihrer Ansteuerung mindestens eine weitere Metallisierung ihrer ersten Hauptfläche auf, die elektrisch von der Laststrom leitenden getrennt ist und nach dem Stand der Technik ebenfalls mittels einer Bondverbindung mit einer dritten Leiterbahn eines Substrats verbunden ist.

Ausgangspunkt zur erfindungsgemäßen Weiterbildung der Bondverbindung für die Laststrom leitende Verbindung zwischen einer zweiten Leiterbahn und einem Leistungshalbleiterbauelement ist ein elektrisch isolierendes Substrat mit hierauf angeordneten Leiterbahnen, wobei auf einer ersten Leiterbahn ein Leistungshalbleiterbauelement angeordnet ist. Diese erste Leiterbahn dient der Stromzu- oder abführung von der dieser Leiterbahn zugewandeten zweiten Hauptfläche des Leistungshalbleiterbauelements. Zur Stromzu- oder abführung des Laststroms zur ersten Hauptfläche des Leistungshalbleiterbauelements ist eine Bondverbindung zwischen der Metallisierung dieser ersten Hauptfläche und einer zweiten Leiterbahn vorgesehen.

Die erfindungsgemäß weitergebildete Bondverbindung von einer zweiten Leiterbahn zu einer Metallisierung des Leistungshalbleiterbauelement weist eine Mehrzahl von einzelnen Bonddrähten, oder auch Bondbändern, auf, die ihrerseits eine Mehrzahl von Bondfüßen auf der Metallisierung des Leistungshalbleiterbauelements aufweisen. Diese Bondfüße sind hierbei schachbrettartig angeordnet, wobei die Bondfüße hier nur auf Feldern gleicher "Farbe" angeordnet sind.

Vorteilhaft an einer erfindungsgemäßen Ausgestaltung einer Bondverbindung für Leistungshalbleiterbauelemente ist, dass hiermit dieses Leistungshalbleitermodul gleichmäßig über seine Fläche belastet wird, die Stoßstrombelastung erhöht wird und/oder in Ausgestaltungen mit einer geringeren Anzahl von Bonddrähten oder Bondbändern die gleiche Leistungsfähigkeit wie bei Bondverbindungen nach dem Stand der Technik erzielt wird.

Die erfinderische Lösung wird an Hand der Fig. 1 bis 7 weiter erläutert.

Fig. 1 zeigt eine Bondverbindung nach dem Stand der Technik in Draufsicht.

Fig. 2 zeigt eine Bondverbindung nach dem Stand der Technik in der Seitenansicht.

Fig. 3 zeigt eine erste erfindungsgemäß weitergebildete Bondverbindung in Draufsicht.

Fig. 4 zeigt eine der ersten ähnliche erfindungsgemäß weitergebildete Bondverbindung in der Seitenansicht.

Fig. 5 zeigt eine zweite erfindungsgemäß weitergebildete Bondverbindung in Draufsicht.

Fig. 6 zeigt eine dritte erfindungsgemäß weitergebildete Bondverbindung in der Seitenansicht.

Fig. 7 zeigt eine vierte erfindungsgemäß weitergebildete Bondverbindung in der Seitenansicht.

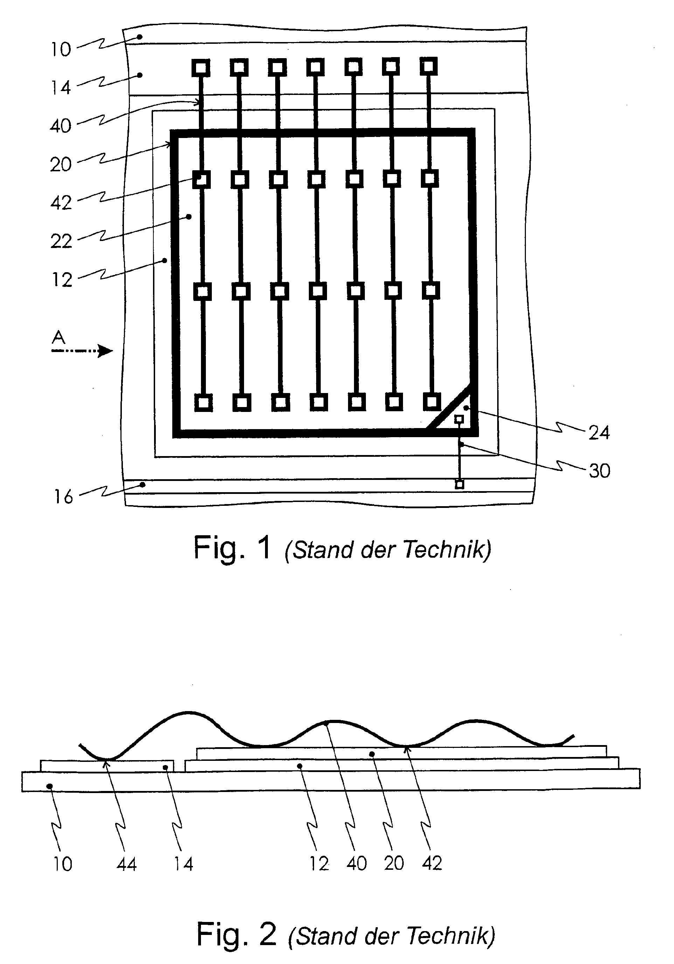

Fig. 1 zeigt eine Bondverbindung nach dem Stand der Technik in Draufsicht. Dargestellt ist hierbei ein elektrisch isolierendes Substrat (10) mit drei hierauf angeordneten elektrisch voneinander isolierten Leiterbahnen (12, 14, 16). Auf der ersten dieser Leiterbahnen (12) ist ein Leistungstransistor (20) angeordnet und mit seiner zweiten Hauptfläche mit dieser Leiterbahn (12) mittels einer Lötverbindung oder einer anderen Verbindung nach dem Stand der Technik elektrisch leitend verbunden. Alternativ sind auch andere bekannte gesteuerte oder ungesteuerte Leistungshalbleiterbauelement wie Leistungsdioden oder Leistungsthyristoren vorzusehen.

Der Leistungstransistor (20) weist auf seiner dem Substrat abgewandten ersten Hauptfläche zwei Metallisierungen (22, 24) auf. Eine erste Metallisierung (22) bildet die Laststromzuführung in den Leistungstransistor (20), eine zweite Metallisierung (24) ist der Steueranschluss des Leistungstransistors (20). Dieser Steueranschluss ist mittels einer aus einem Bonddraht (30) bestehenden Bondverbindung mit einer dritten Leiterbahn (16) des Substrats verbunden.

Die Laststrom leitende Verbindung ist ausgebildet als eine Mehrzahl gleichartiger Bondrähte (40) zwischen der Metallisierung (22) des Leistungstransistors (20) und der zweiten Leiterbahn (14), wobei nach dem Stand der Technik auch Bondbänder vorsehbar sind. Diese Bonddrähte (40) oder Bondbänder weisen jeweils eine Mehrzahl von Bondfüßen (42) auf. Gemäß dem Stand der Technik sind die Bondfüße (42) benachbarter Bonddrähte (40) benachbart zueinander angeordnet.

Fig. 2 zeigt eine Bondverbindung gemäß Fig. 1 in der Seitenansicht aus Richtung A. Hierbei ist wiederum das elektrisch isolierende Substrat (10), beispielhaft bestehend aus einer Industriekeramik wie Aluminiumoxid, mit zwei hierauf angeordneten Leiterbahnen (12, 14) dargestellt. Auf der ersten Leiterbahn (12) ist das Leistungshalbleiterbauelement (20), der Leistungstransistor, angeordnet. Auf die Darstellung des Steueranschlusses und der zugehörigen Leiterbahn und Bondverbindung wird hier zugunsten der Übersichtlichkeit verzichtet.

Die Bondverbindung nach dem Stand der Technik ist als eine Mehrzahl in Blickrichtung direkt hintereinander angeordneter Bonddrähte (40) mit je einem Bondfuß (42) auf der zweiten der Laststrom zuführenden Leiterbahn (14) und je drei Bondfüßen (42) auf der zugeordneten Metallisierung (22) des Leistungstransistors (20) ausgebildet.

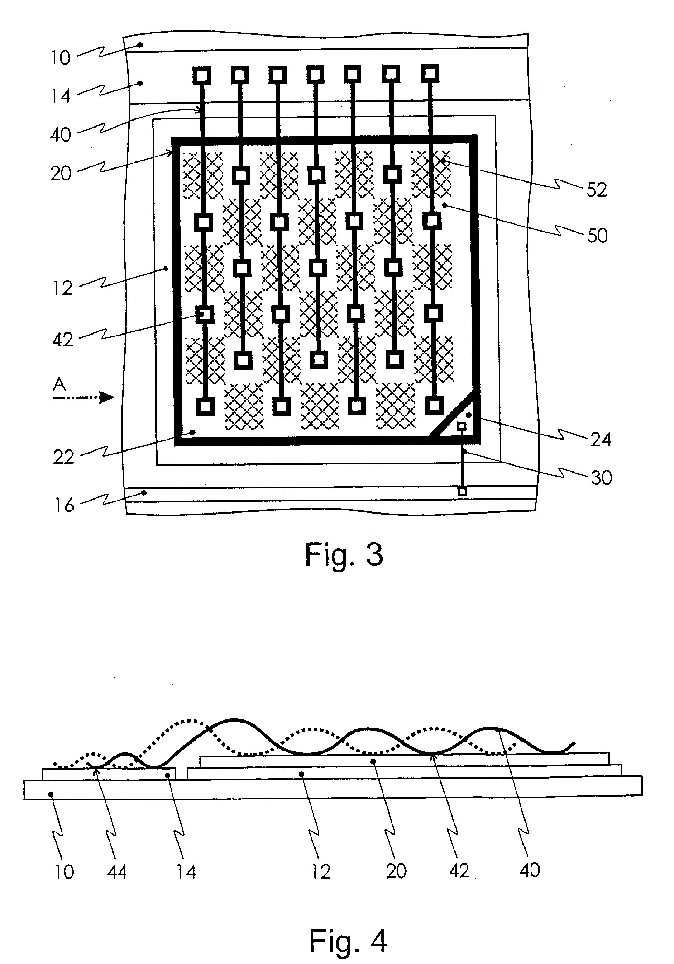

Fig. 3 zeigt eine erste erfindungsgemäß weitergebildete Bondverbindung in Draufsicht. Dargestellt ist wiederum wie in Fig. 1 das Substrat (10) mit drei Leiterbahnen (12, 14, 16) und einem auf der ersten Leiterbahn (12) angeordnetem Leistungstransistor (20), wobei hier ebenfalls alle bekannten Leistungshalbleiterbauelement vorsehbar sind. Die Laststrom leitende Bondverbindung ist wiederum als eine Mehrzahl von Bondbändern oder Bonddrähten (40) ausgebildet. Vorzugsweise sind für die erfindungsgemäße Ausgestaltung dieser Bondverbindung mindestens vier Bonddrähte oder Bondbänder (40) vorgesehen, wobei jeder Bonddraht (40) oder jedes Bondband mindestens zwei Bondfüße (42) auf der zugeordneten Metallisierung (22) des Leistungshalbleiterbauelements (20) aufweist.

Erfindungsgemäß sind die Bondfüße (42) zweier benachbarter Bondrähte (40), oder Bondbänder, was hier im weiteren als synonym angenommen wird, gegeneinander derart versetzt, dass jeweils ein Bondfuß (42) des zweiten Bonddrahts bei Ansicht in Richtung A zwischen zwei Bondfüßen des ersten Bonddrahts angeordnet ist. Somit ergibt sich eine schachbrettartige Verteilung der Bondfüße (42) auf der Metallisierung (22) des Leistungstransistors (20), wobei Bondfüße (42) nur auf Feldern gleicher "Farbe" (50, 52) angeordnet sind. Dies wird dargestellt durch schraffierte und nicht schraffierte Bereiche die somit "Felder" gleicher "Farbe" darstellen. Hier sind Bondfüße nur auf "weißen Feldern" (50) angeordnet.

Diese schachbrettartige Anordnung der Bondfüße (42) gewährleistet, dass die Stromzuleitung homogen über die gesamte Metallisierung (22) des Leistungstransistors (20) verteilt wird und nicht streifenförmige Bereiche, wie in Fig. 1 ersichtlich, besonders belastet werden. Die homogene Verteilung der Stromzuleitung kommt der gesamten Leistungsfähigkeit des Leistungshalbleiterbauelements zugute, speziell vorteilhaft ist sie allerdings bei Stoßstrombeaufschlagung.

Fig. 4 zeigt eine erst erfindungsgemäß weitergebildete Bondverbindung vergleichbar Fig. 3 aus der dortigen Ansicht A. Dargestellt ist wiederum wie auch in Fig. 2 das Substrat (10), die Leiterbahnen (12, 14) und ein Leistungshalbleiterbauelement (20). Im Gegensatz zu Fig. 3 in der die Laststrom leitende Bondverbindung auf der zweiten Leiterbahn (14) nur einen Bondfuß (42) aufweist, sind in dieser Ausgestaltung zwei Bondfüße (42) je Bonddraht (40) auf der zweiten Leiterbahn (14) vorgesehen. Dies hat den Vorteil auf der Leiterbahn (14) die Verbindung zwischen dem Bonddraht (40) und der Leiterbahn (14) mittels zweier und damit nur jeweils halb belasteter Kontaktflächen auszubilden. Erfindungsgemäß sind auch hier die Bondfüße (42) auf der zweiten Leiterbahn (14) schachbrettartig angeordnet.

Die Bondfüße (42) auf der zugeordneten Metallisierung (22) des Leistungshalbleiterbauelements (20) ist identisch derjenigen gemäß Fig. 3. Hier dargestellt ist die Anordnung zweier Bonddrähte (40) hintereinander gemäß Blickrichtung A, wobei der Versatz der Bondfüße (42) zweier benachbarter Bonddrähte deutlich erkennbar ist.

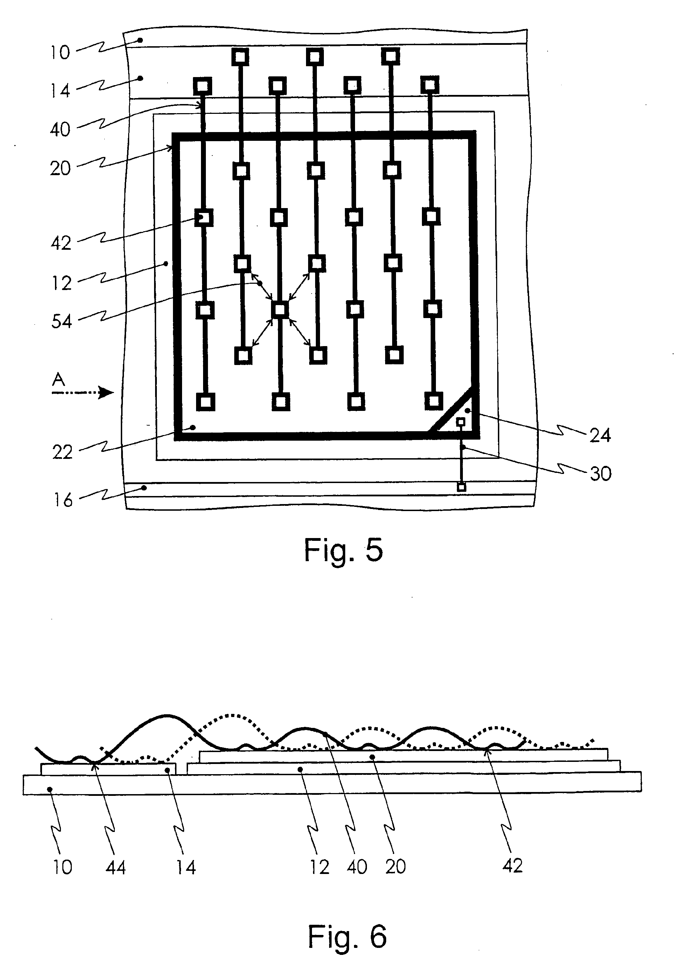

Fig. 5 zeigt eine zweite erfindungsgemäß weitergebildete Bondverbindung in Draufsicht. Hierbei entspricht die schachbrettartige Anordnung der Bondfüße (42) auf der Metallisierung (22) des Leistungshalbleiterbauelements (20) wieder derjenigen gemäß Fig. 3. Weiterhin ist hierbei dargestellt, dass die Abstände (54) eines Bondfußes (42) auf der Metallisierung (22) zu seinen vier nächsten Nachbarn bis auf den zehnten Teil ihrer Länge gleich sind.

Im Gegensatz zu Fig. 3 sind die Bondfüße (42) der Bondverbindung auf der zweiten Leiterbahn (14) gegeneinander versetzt. Dies führt zu einer Symmetrierung aller Bondverbindungen, weil hierbei auch die erste Schleife von der zweiten Leiterbahn (14) zum ersten Bondfuß (42) auf der Metallisierung (22) bei allen Bonddrähten (40) annährend gleich lang ausgebildet ist.

Fig. 6 zeigt eine weitere erfindungsgemäß weitergebildete Bondverbindung in der Seitenansicht. Hierbei ist wiederum die erfindungsgemäße schachbrettartige Anordnung der Bondfüße (42) auf der Metallisierung (22) des Leistungshalbleiterbauelements (20) dargestellt. Allerdings weist hierbei ein Bondfuß (42) eine Mehrzahl von Kontaktflächen mit der Metallisierung (22) des Leistungshalbleiterbauelements (20) und mit der zweiten Leiterbahn (14) auf. Diese einzelnen Kontaktflächen liegen eng benachbart zueinander und weisen einen Abstand voneinander auf der kleiner ist als der dreifache Durchmesser des Bonddrahts (40).

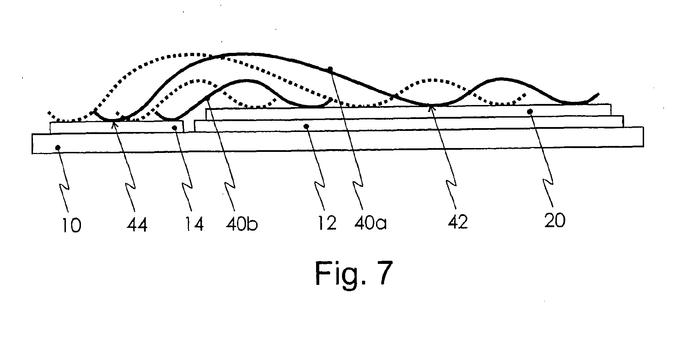

Fig. 7 zeigt eine vierte erfindungsgemäß weitergebildete Bondverbindung in der Seitenansicht. Hierbei ist wiederum die erfindungsgemäße schachbrettartige Anordnung der Bondfüße (42) auf der Metallisierung (22) des Leistungshalbleiterbauelements (20) dargestellt. Allerdings werden die Bondfüße (42) im Verlauf des Bonddrahtes (40) durch eine Mehrzahl von Bonddrähten (40 a/b) übereinander gebildet. Eine derartige Ausgestaltung mit einer Mehrzahl von Bonddrähten (40 a/b) erhöht die Stromtragfähigkeit der gesamten Bondverbindung weil diese mit der Summe der Querschnittsflächen aller Bonddrähte (40) skaliert.

## Patentansprüche

1. Bondverbindung, ausgebildet als eine Mehrzahl von Bondbändern oder Bonddrähten (40), als Laststrom leitende Verbindung einer Leiterbahn mit einem Leistungshalbleiterbauelement (20) und am Leistungshalbleiterbauelement pro Bondband oder Bonddraht jeweils eine Mehrzahl von Bondfüssen aufweisend,
mit einem elektrisch isolierenden Substrat (10), hierauf angeordneten Leiterbahnen (12, 14, 16), mindestens einem auf einer ersten Leiterbahn (12) angeordneten und mit mindestens einer zweiten Leiterbahn (14) verbunden Leistungshalbleiterbauelement (20), wobei
dieses Leistungshalbleiterbauelement (20) auf seiner der ersten Leiterbahn (12) abgewandten ersten Hauptfläche mindestens eine Metallisierung (22) aufweist und die Bondverbindung derart ausgebildet ist, dass die Bondfüße (42) auf der Metallisierung (22) des Leistungshalbleiterbauelements (20) schachbrettartig nur auf Feldern der gleichen Farbe (50) angeordnet sind.

2. Bondverbindung nach Anspruch 1, wobei
die Bondfüße (42) der Bondverbindung auf der zu verbindenden zweiten Leiterbahn (14) gegeneinander versetzt oder schachbrettartig nur auf Feldern der gleichen Farbe angeordnet sind.

3. nach Anspruch 1, wobei
die Abstände (54) eines Bondfußes (42) zu seinen vier nächsten Nachbarn bis auf den zehnten Teil ihrer Länge gleich sind.

4. Bondverbindung nach Anspruch 4, wobei
die Bondverbindung mindestens vier Bonddrähte (40) oder Bondbänder aufweist und jeder Bonddraht (40) oder jedes Bondband mindestens zwei Bondfüße (42) auf der Metallisierung (22) des Leistungshalbleiterbauelements (20) aufweist.

5. nach Anspruch 1, wobei
ein Bondfuß (42) eine Mehrzahl von Kontaktflächen mit der Metallisierung (22) des Leistungshalbleiterbauelements (20) oder mit der zweiten Leiterbahn (14) aufweist.

6. Bondverbindung nach Anspruch 1, wobei
eine Mehrzahl von Bonddrähten (40 a/b) oder Bondbändern übereinander angeordnet sind.

7. nach Anspruch 1, wobei
das Leistungshalbleiterbauelement (20) eine Leistungsdiode oder ein Leistungstransistor oder ein Leistungsthyristor ist.

## Claims

1. A bond connection, constructed as a plurality of bond strips or bond wires (40) and as a connection of a conductor track conducting load current, with a
power semiconductor component (20) and for each bond strip or bond wire in each case having a plurality of bond feet on the power semiconductor component,
with an electrically insulating substrate (10), conductor tracks (12, 14, 16) arranged thereon, at least one power semiconductor component (20) arranged on a first conductor track (12) and connected to at least one second conductor track (14), wherein
this power semiconductor component (20) has at least one metallisation (22) on its first main surface facing away from the first conductor track (12) and the bond connection is constructed in such a manner that the bond feet (42) are arranged on the metallisation (22) of the power semiconductor component (20) in the manner of a chess board only on squares (50) of the same colour.

2. The bond connection according to Claim 1, wherein
the bond feet (42) of the bond connection are arranged offset to one another or only on squares of the same colour in the manner of a chess board on the second conductor track (14) to be connected.

3. The bond connection according to Claim 1, wherein
the distances (54) of a bond foot (42) from the four closest neighbours thereof are equal up to the tenth part of the length thereof.

4. The bond connection according to Claim 4, wherein
the bond connection has at least four bond wires (40) or bond strips and each bond wire (40) or each bond strip has at least two bond feet (42) on the metallisation (22) of the power semiconductor component (20).

5. The bond connection according to Claim 1, wherein
a bond foot (42) has a plurality of contact surfaces with the metallisation (22) of the power semiconductor component (20) or with the second conductor track (14).

6. The bond connection according to Claim 1, wherein
a plurality of bond wires (40 a/b) or bond strips are arranged above one another.

7. The bond connection according to Claim 1, wherein
the power semiconductor component (20) is a power diode or a power transistor or a power thyristor.

## Revendications

1. Connexion par bonding, réalisée sous la forme d'une pluralité de rubans de bonding ou de fils de bonding (40) en tant que liaison conductrice de courant de charge d'une piste conductrice avec un composant semi-conducteur de puissance (20) et comportant une pluralité de plots de connexion sur le composant semi-conducteur de puissance par ruban de bonding ou par fil de bonding,
avec un substrat (10) électriquement isolant, des pistes conductrices (12, 14, 16) disposées sur celui-ci, au moins un composant semi-conducteur de puissance (20) disposé sur une première piste conductrice (12) et relié à au moins une deuxième piste conductrice (14),
ledit composant semi-conducteur de puissance (20) présentant au moins une métallisation (22) sur sa première surface principale distante de la première piste conductrice (12) et la connexion par bonding étant réalisée de telle manière que les plots de connexion (42) sur la métallisation (22) du composant semi-conducteur de puissance (20) ne soient disposés que sur des champs (50) de même couleur à la manière d'un damier.

2. Connexion par bonding selon la revendication 1,
les plots de connexion (42) de la connexion par bonding sur la deuxième piste conductrice (14) à connecter étant décalés les uns par rapport aux autres ou n'étant disposés que sur des champs de même couleur à la manière d'un damier.

3. Connexion par bonding selon la revendication 1,
les espacements (54) entre un plot de connexion (42) et ses quatre proches voisins étant identiques, à l'exception de la dixième partie de leur longueur.

4. Connexion par bonding selon la revendication 4,
ladite connexion par bonding comportant au moins quatre fils de bonding (40) ou rubans de bonding et chaque fil de bonding (40) ou chaque ruban de bonding comportant au moins deux plots de connexion (42) sur la métallisation (22) du composant semi-conducteur de puissance (20).

5. Connexion par bonding selon la revendication 1,
un plot de connexion (42) comportant une pluralité de surfaces de contact avec la métallisation (22) du composant semi-conducteur de puissance (20) ou avec la deuxième piste conductrice (14).

6. Connexion par bonding selon la revendication 1,
une pluralité de fils de bonding (40 a/b) ou de rubans de bonding étant superposés.

7. Connexion par bonding selon la revendication 1,
le composant semi-conducteur de puissance (20) étant une diode de puissance, un transistor de puissance ou un thyristor de puissance.
